# EUROPEAN PATENT SPECIFICATION

(11) **EP 0 327 406 B1**
(45) Date of publication and mention of the grant of the patent: **14.10.1998**
(21) Application number: 89301126.2
(22) Date of filing: 06.02.1989
(51) Int. Cl.: H01J 37/32, H01J 37/34

(54) **Plasma processing method and apparatus for the deposition of thin films**
Plasmabearbeitungsmethode und Vorrichtung zum Aufbringen von Dünnschichten
Procédé d'usinage à plasma et dispositif pour le dépôt de couches minces

(30) Priority: 05.02.1988 JP 25919/88; 05.02.1988 JP 25920/88; 13.05.1988 JP 117792/88; 26.08.1988 JP 212890/88; 11.10.1988 JP 255489/88
(43) Date of publication of application: 09.08.1989
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo (JP); Tsuchiya, Mitsunori, Atsugi-shi Kanagawa-ken (JP); Kawano, Atsushi, Atsugi-shi Kanagawa-ken (JP); Imatou, Shinji, Atsugi-shi Kanagawa-ken (JP); Nakashita, Kazuhisa, Atsugi-shi Kanagawa-ken (JP); Hamatani, Toshiji, Atsugi-shi Kanagawa-ken (JP); Inushima, Takashi, Atsugi-shi Kanagawa-ken (JP); Itou, Kenji, Zama-shi Kanagawa-ken (JP)
(74) Representative: Milhench, Howard Leslie

(56) References cited:
- EP-A- 0 188 206
- US-A- 4 464 223
- US-A- 4 723 508
- Solid State Technology, Vol.26, No.4, April 1983, pages 191-195; W.L.Johnson: "Design of Plasma Deposition Reactors"
- Brian Chapman: Glow Discharge Processes, Sputtering and Plasma Etching, John Wiley & Sons, New York 1980; pages 153-155 and 326-328

## Description

### Field of the Invention

The present invention relates to a plasma processing method and apparatus. More specifically, the present invention relates to a plasma chemical vapour deposition method, a plasma processing method and a plasma processing apparatus for the deposition of thin films as defined in the first parts of independent claims 1, 3 and 14, respectively. Such method and apparatus are known from EP-A-0 188 206.

### Background of the Invention

The formation of carbon thin films having very high hardness by a process utilising chemical vapour reactions, has recently attracted the interest of researchers, particularly because the high hardness of such carbon films provides a smooth, wear-resistant and corrosion-proof surface. However, difficulties have arisen in the prior art in that it has not been possible, or has not readily been possible, to process a large area or a number of substrates all at the same time. Furthermore, difficulties have been experienced when an uneven surface is desired to be coated or processed in that relatively little deposition takes place in depressions in the surface being treated.

US 4464223 describes a plasma reactor apparatus and method in which a plasma is established in a reaction chamber containing a reactive gas in order to effect etching of a workpiece placed on an electrical field generating electrode in the chamber.

US 4723508 describes a plasma CVD apparatus in which substrates are disposed within a plasma generation region. Films are deposited on the substrates, which are held at ground potential, through a plasma CVD process.

In Solid State Technology, Vol. 26, No. 4, April 1983, pages 191-195, W.L. Johnson: "Design of Plasma Deposition Reactors"; a method of CVD is described in which a plasma is generated in a glow discharge region between two electrodes.

In Brian Chapman: "Glow Discharge Processes, Sputtering and Plasma Etching", John Wiley & Sons, New York 1980; pages 153-155 and 326-328, a method of triode plasma etching is described, wherein a substrate is placed on an electrically biased holder which is provided outside but adjacent a plasma generating space.

EP-A-0188206 describes a system for plasma processing in which a plasma is induced between two high-frequency electrodes and a DC-biased substrate is positioned between the electrodes.

### Summary of the Invention

It is thus desired to provide a plasma processing method and apparatus that is capable of performing plasma processing over a relatively large processing area.

In addition, it is desired to provide a plasma processing method and apparatus that is capable of producing a relatively high throughput of electric devices.

According to one aspect of the invention, there is provided a plasma chemical vapour deposition method in which a plasma is generated for deposition throughout a plasma generating space provided between a pair of electrodes in a reaction chamber, said method comprising: disposing in the plasma generating space at least one substrate on a substrate holder spaced apart from said pair of electrodes ; supplying a reactive gas to said plasma generating space; inducing the plasma throughout said plasma generating space by applying high-frequency electrical energy to said reactive gas; depositing a material on the surface of said substrate from said reactive gas through a chemical vapour deposition; and applying a bias voltage to said substrate during said deposition; characterised in that said bias voltage comprises alternating current electrical energy and is applied in order to expedite sputtering action at said surface.

According to another aspect of the invention, there is provided a plasma processing method in which a plasma is generated throughout a plasma generating space provided between a pair of electrodes in a reaction chamber, said method comprising: placing in said plasma generating space at least one substrate on a substrate holder spaced apart from said pair of electrodes ; introducing a reactive gas into said reaction chamber; supplying an AC voltage between said pair of electrodes in order to convert said reactive gas to a plasma; treating a surface of said substrate with said plasma; and applying a bias voltage to said substrate; characterised in that said bias voltage comprises alternating current electrical energy and is applied in order to expedite sputtering action at said surface.

According to another aspect of the invention, there is provided a plasma processing apparatus comprising: a reaction chamber; a gas supply system associated with said chamber for supplying process gases thereto; a vacuum pump for evacuating said reaction chamber and maintaining a suitable gas pressure in said reaction chamber; first and second parallel electrodes spaced apart from each other in said reaction chamber; a plasma generating space provided between said first and second electrodes; a substrate holder provided in said plasma generating space and spaced apart from each of said first and second electrodes; a high-frequency power source for applying high-frequency electrical energy between said first and second electrodes at a frequency for effecting the generation of a plasma throughout said plasma generating space when process gases are introduced into the reaction chamber; and a biassing power source for applying a bias voltage to said substrate holder; characterised in that said biassing power source comprises an alternating current power source such that a substrate supported by said substrate holder will be substantially subjected to sputtering action of the plasma generated throughout the plasma generating space.

As described more particularly hereinafter with reference to exemplary embodiments of the invention a plasma of reactive gas is created between a pair of electrodes to which high frequency electrical energy is supplied, and a number of substrates are disposed within the plasma space and subjected to an alternating electric field. Glow discharge takes place by virtue of the application of high frequency power between the pair of electrodes and, by virtue of the alternating voltage supplied to the substrates, sputtering is effected thereto. The sputtering action has two functions, namely during deposition it enables amorphous films to be deposited, and during etching it increases the etching speed.

Carbon films can for example be deposited in accordance with the teachings of the present invention in the form of so-called diamond-like carbon whose Vickers hardness might be expected to be 6500 Kg/mm² or higher depending on the formation conditions and whose energy gap is not lower than 1.0 eV and more preferably will be in the region of 1.5 to 5.5 eV. When used for coating thermal heads which are frequently subjected to rubbing, the smooth and hard surface of such carbon films is very advantageous. When used in integrated circuits and semiconductor devices, the high thermal conductivity of such carbon films makes it more readily possible to dissipate the heat that is generated in operation of the integrated circuit or semiconductor device and thereby avoid problems associated with high temperature. It is also possible to fabricate carbon films containing diamond particles by adjusting the deposition conditions and such films are useful for their abrasive properties.

Phosphorus or diborane for example may be introduced into the plasma with a carbon containing reactive gas in order to make the deposited film semiconductive. After completion of deposition, the reaction chamber may be cleaned by effecting plasma etching with argon for example by the plasma process in accordance with an embodiment of the present invention.

Other features of the invention are set forth in the appended claims and, together with the features abovementioned, will become clear to one possessed of the relevant skills from a reading of the following description of exemplary embodiments of the invention which is given with reference to the accompanying drawings.

### Description of the Drawings

Fig. 1 is a schematic diagram showing an exemplary plasma chemical vapour reaction apparatus in accordance with an embodiment of the present invention;
Figs. 2(A), 2(B) and 2(C) are schematic diagrams showing modifications of the substrate holder of the apparatus illustrated in Fig. 1;
Figs. 3(A) to 3(C) are cross-sectional views showing stages in the fabrication of carbon patterns in accordance with an embodiment of the present invention;
Fig. 4 is a schematic diagram showing another exemplary plasma processing apparatus in accordance with an embodiment of the present invention;
Figs. 5(A) and 5(B) are plan views showing modifications of the substrate holder of the apparatus illustrated in Fig. 4;
Figs. 6(A) to 6(D) are cross-sectional views showing the deposition of carbon films on OPC printing drums;
Fig. 7 is a schematic diagram showing a modification of the apparatus illustrated in Fig. 4; and
Figs. 8(A) and 8(B) are cross-sectional views illustrating the deposition of wear resistant coatings onto glass substrates.

### Detailed Description of the Embodiments

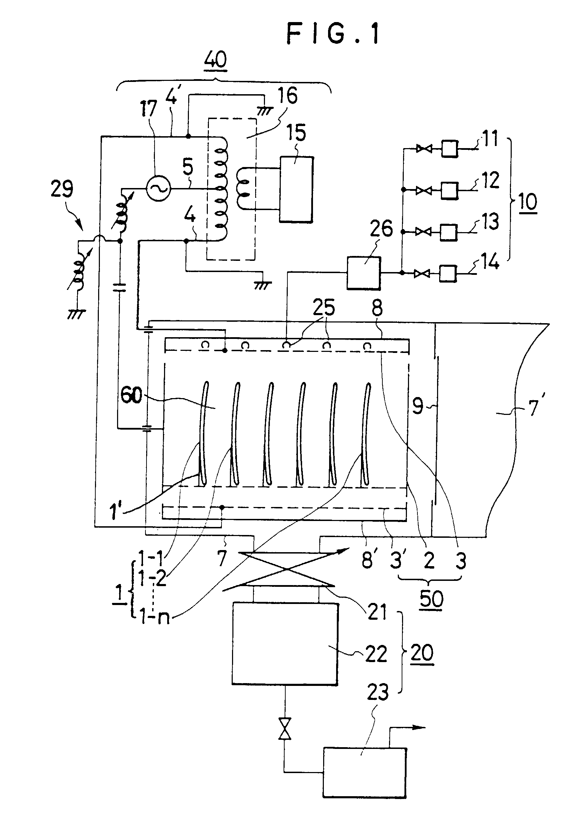

Referring to Fig. 1, this is a schematic showing of a plasma CVD apparatus in accordance with an embodiment of the present invention for use in depositing carbon films for example. The apparatus comprises a loading and unloading chamber 7', a reaction chamber 7 connected to the loading chamber 7' through a gate valve 9, a vacuum system provided for evacuating the reaction chamber 7 and consisting of a pressure control valve 21, a turbo molecular pump 22 and a rotary pump 23, a gas feeding system 10 for introducing process gases into the reaction chamber 7 through nozzle 25, a substrate holder 1' functioning also as an electrode, a pair of mesh or grid electrodes 3 and 3', and a high frequency electric energy supply 40 connected with the substrate holder 1' and the mesh electrodes 3 and 3' and consisting of a high frequency power source 15, a matching transformer 16, an AC power source 17 and bias applying means 29. A temperature controlling means is provided in the chamber 7 in order to maintain the temperature of the reactive gas, between 450°C and -100°C for example, although not illustrated in the figure.

The output frequency of the high frequency power source 15 is from 1 to 50 MHz, e.g. 13.56 MHz. The pair of electrodes 3 and 3' are connected respectively to the ends 4 and 4' of the secondary coil of the transformer 16. The substrate holder 1' is electrically connected to the midpoint 5 of the secondary coil through the AC power source 17 and the bias applying means 29. The frequency of the AC source is from 1 to 500 KHz, e.g. 50 KHz. The plasma generating space 60 between the electrodes 3 and 3' is confined by an enclosure 2 whose upper and lower openings are closed by a pair of lids 8 and 8'. The enclosure is a four-sided rectangle of 20 cm to 1 m height and 30 cm to 3 m width. Optionally, a microwave excitation device 26 may be provided in association with the gas feeding system 10, the device 25 serving to energise the reactive gas supplied from the gas feeding system 10 by subjecting it to microwave energy, at for example, 2.45 GHz and from 200W to 2KW. By use of the device 25, the deposition speed and the etching speed that can be achieved in use of the apparatus can be increased by a factor of about 5 and by a factor of about 4 respectively.

A method of depositing carbon films will be described hereinbelow. Substrates 1 to be coated are placed in the loading chamber 7'. After evacuating the loading and reaction chamber 7 and 7', the substrates 1 are transferred to the reaction chamber 4 through the gate valve 9. In the illustration, the substrate 1 are dishes. The rear surfaces of the dishes have a vacuum evaporated aluminium coating and the substrate holder 1' is adapted to support the dishes with electrical connection made between the substrate holder and the aluminium film.

A reactive gas is admitted to the reaction chamber 7 through the gas feeding system 10. The reactive gas includes a carbon compound gas such as for example CH₄, C₂H₄, C₂H₂, CH₃OH or C₂H₅OH. For example, H₂ and CH₄ are inputted through the line 11 and the line 12 respectively at the same rate. The hydrogen content of the carbon film to be subsequently deposited can be controlled by adjusting the proportion of hydrogen in the reactive gas. Preferably, the hydrogen content of the film is not higher than 25 mol%. In addition to the reactive gas, a dopant gas may be introduced for the purpose of introducing impurities into the carbon. Examples of such impurities are N (not higher than 5 atom%), boron or phosphorus (0.1 to 5 atom%) or a halogen (not higher than 25 atom%). The introduction of dopant gas may be made respectively in the form of NH₃, B₂H₆, PH₃ and C₂F₆ or C₃F₈.

High frequency electric power at 13.56 MHz is applied to the reactive gas from the high frequency power source 15 at 0.5 to 5 KW. The output power is equivalent to a plasma energy of 0.03 to 3 W/cm². For example, the output power may be 1 KW (0.6 W/cm²). At the same time, an alternating electric voltage at 50 KHz is applied to the substrate holder and thus to the substrates 1 by the AC source 17. The alternating voltage applied to the substrates 1 is biassed by -200V to +600V by the bias device 29. The actual bias potential at the substrates 1 is -400 to +400V since a self bias voltage is spontaneously applied thereto even without the application of an external bias. Preferably, the bias is applied so that the substrates function as cathodes.

As a result of the abovementioned conditions, a plasma gas is generated in the reaction chamber 7 and carbon deposition takes place on the substrates 1. The deposition speed can reach 10 to 100 nm/min (100 to 1000 Å/min) in a highly dense plasma. When deposition is carried out without injection of microwave energy and a 100 to 300V bias voltage is superimposed on the alternating voltage from the AC source 17, the deposition speed is around 10 to 20nm/min (100 to 200 Å/min). When deposition is carried out with the injection of microwave energy and a 100 to 300 V bias voltage is employed, the deposition speed is increased to around 50 to 100 nm/min (500 to 1000 Å/min). The pressure of the reactive gas is maintained at 133.3 Pa to 1.33 Pa, e.g. 13.33 Pa (1 to 0.01 Torr, e.g. 0.1 Torr), in the reaction chamber 7. The substrate temperature is from 50 to 150°C without particular heating. By virtue of this process a carbon film of from 5 nm to 10 µm (50Å to 10 microns) thickness can be deposited on the substrates 1. The carbon film consists of an amorphous carbon which, depending on the deposition conditions, may contain microcrystals of from 0.5 nm to 2 µm (5 Å to 2 microns) diameter. The Vickers hardness of the carbon film is not lower than 2000 Kg/mm² and its thermal conductivity is not less than 4.36 W/m rad (2.5 W/cm deg), and typically from 6.98 to 10.47 W/m rad (4.0 to 6.0 W/cm deg). The carbon film is characterised by C-C bonds of sp³. Exhausted gas is removed through the evacuating system 21 to 23.

Microwave energy at 1 GHz or a higher frequency, e.g. 2.45 GHz, can break C-H bonds while C-C, C=C can be broken at 0.1 to 50 MHz, e.g. 13.56 MHz. The amount of hydrogen in the carbon films is preferably not higher than 25 mol%. Optionally, it is useful to add an impurity such as phosphorus, nitrogen or boron in order to fabricate carbon n-type or p-type semiconductors.

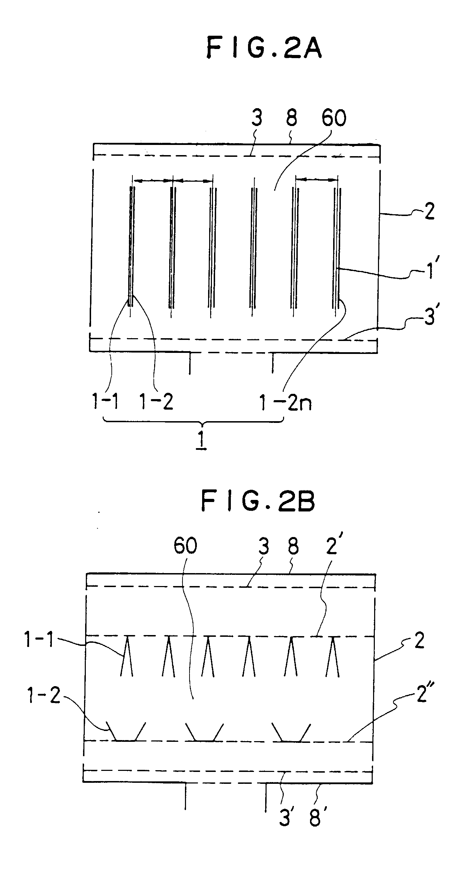

The substrate holder may be modified in accordance with the nature of the substrates to be coated. Figs. 2(A) and 2(B) are schematic diagrams showing examples. In Fig. 2(A), a number of substrate holders 1' in plate form is provided as integral parts of the enclosure 2. A pair of substrates are mounted on opposed sides of each holder. The distance between adjacent holders is chosen to be from 6 to 10 cm. The size of the holder is 60 cm x 30 cm. The substrates cover the entire surface of the holders, except for marginal portions thereof 10 cm from the lateral ends and 5 cm from the upper and lower ends respectively. With this arrangement, the thickness of the carbon films that were obtained were 1 micron ± 5%. In order to suspend pincettes 1-1, a metallic mesh 2' may be provided in the enclosure 2 as shown in Fig. 2(B). Also, vessels 1-2 may be placed on a mesh 2".

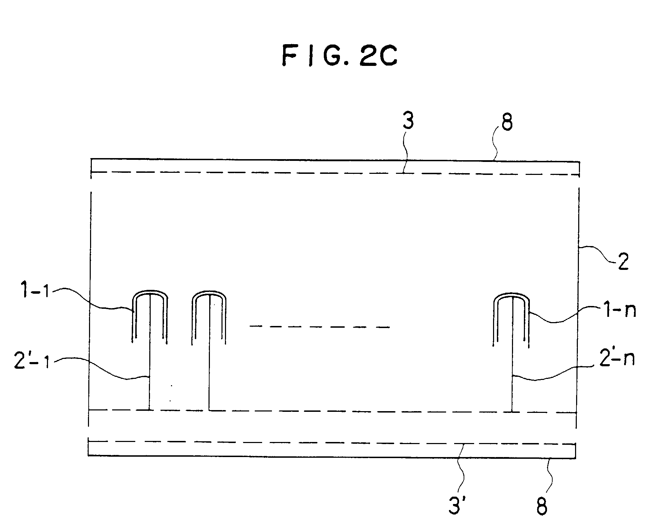

Although the rear surface of the substrate to be coated is preferably made conductive, the provision of a conductive coating may be dispensed with. An example is described in conjunction with Fig. 2(C). This example concerns the treatment of a number of drinking glasses. In the enclosure 2, there are provided a number of supporting members 2'-1 to 2'-n made of a conductive material such as aluminium. The support members are provided with glass receivers made of stainless steel shaped in the form of glasses and adapted to make contact with the inner surface of glasses to be supported. In accordance with the results of experiments that we have conducted, when the clearance between the inner surface of the glasses and the receivers is as narrow as 2 mm, carbon deposition could be carried out in the same manner as if an aluminium film were directly coated on the inner surface of the glasses. However, when the distance between the glasses and the receivers reached about 10 mm, the effect of the conductive receivers could not be confirmed. Alternatively, aluminium foil may be interposed between the receivers and the glasses or may replace the receivers.

An embodiment of the present invention can also be applied to etching processes. After forming carbon films on a substrate, for example, a patterned mask can be coated over the film and then the film can be returned to the chamber to be etched by the introduction of an etchant gas into the reaction chamber 7. The etchant gas may for example be O₂, air, NO₂, NO, N₂O, a mixture of oxygen and hydrogen, or another suitable oxygen compound. A plasma is generated in the same manner as in the deposition process and results in etching of the carbon film. Preferably, the substrate temperature is maintained at from 100 to -100°C during etching. The pressure of the reactive gas is 1.33 to 133.3 Pa (0.01 to 1 Torr).

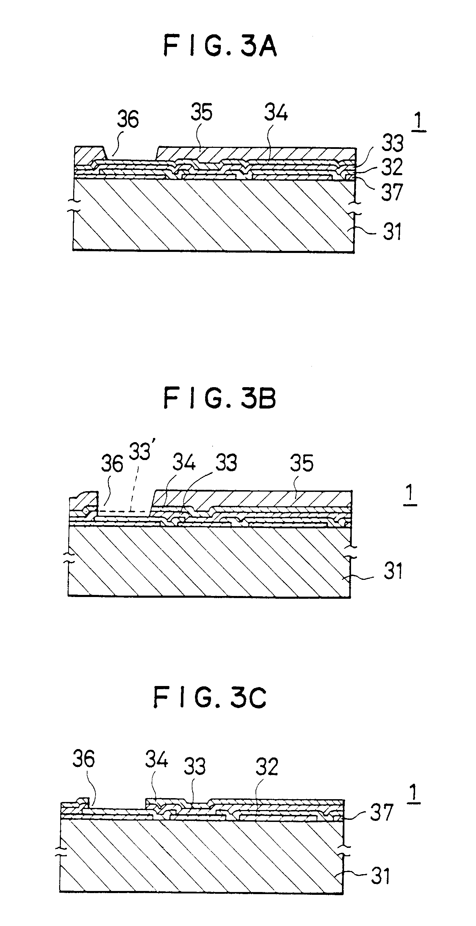

Figs. 3(A) to 3(C) illustrate the manufacture of a semiconductor device including a carbon film pattern by a process in accordance with an embodiment of the present invention. The device was formed within and on a silicon semiconductor substrate 31. A silicon oxide film 37 and a superconducting ceramic film 32 were formed and patterned respectively, followed by a coating of a 0.5 µm (0.5 micron) blocking film 33 which prevents the underlying film 32 from being exposed to etching. The blocking film 33 was made of SiO₂. Then, a carbon film 34 was deposited on the structure to a thickness of from 0.1 to 2 µm, e.g. 0.5 µm (0.1 to 2 microns, e.g. 0.5 micron) . A photoresist pattern was formed on the carbon film 34 with an opening 36. The opening 36 is designated as a bonding pad for making contact with an IC chip. The thickness of the photoresist pattern was selected so that the underlying surface would not be exposed even if the photoresist was partially removed by the following etching. Next, oxygen gas was introduced into the reaction chamber and high frequency power was inputted at 300W to perform etching of the carbon film 34. After completion of the etching, the photoresist 35 and a portion of the blocking film 34 at the opening was removed by etching using NF₃ or SF₆.

Alternatively, the conductive film 32 may be formed of Al, Ag or Si. The blocking film 33 may be formed of a phosphosilicate glass. The thickness of the blocking film may be 0.1 to 2 µm (0.1 to 2 microns) in general. Instead of the thick photoresist pattern, a silicon oxide pattern may be formed by providing a coating of silicon oxide film and etching the same with a photoresist. Silicon oxide is not subject to etching by oxygen.

Superconducting ceramics for use in accordance with an embodiment of the present invention may be prepared to be consistent with the stoichiometric formulae (A₁₋ₓBₓ)_{y}Cu_{z}O_{w}, where A is one or more elements of Group IIIa of the Japanese Periodic Table, e.g. the rare earth elements, B is one or more elements of Group IIa of the Japanese Periodic Table, e.g. the alkaline earth elements, and x = 0.1 - 1; y = 2.0 - 4.0, preferably 2.5 - 3.5; z = 1.0 - 4.0, preferably 1.5 - 3.5; and w = 4.0 - 10.0, preferably 6.0 - 8.0. Also, superconducting ceramics for use in accordance with the present invention may be prepared to be consistent with the stoichiometric formulae (A₁₋ₓBₓ)_{y}Cu_{z}O_{w}, where A is one or more elements of Group Vb of the Japanese Periodic Table such as Bi, Sb, and As; B is one or more elements of Group IIa of the Japanese Periodic Table, e.g. the alkaline earth elements, and x = 0.3 - 1; y = 2.0 - 4.0, preferably 2.5 - 3.5; z = 1.0 - 4.0, preferably 1.5 - 3.5; and w = 4.0 - 10.0, preferably 6.0 - 8.0. Examples of the latter general formulae are Bi₄Sr_{y}Ca₃Cu₄Oₓ, Bi₄Sr_{y}Ca₃Cu₄Oₓ,Bi₄SR_{y}Ca₃Cu₄Oₓ, Bi₄Sr_{y}Ca₃Cu₄Oₓ, Bi₄Sr_{y}Ca₃Cu₄Oₓ,Bi₄SR_{y}Ca₃Cu₄Oₓ, (y is around 1.5).

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

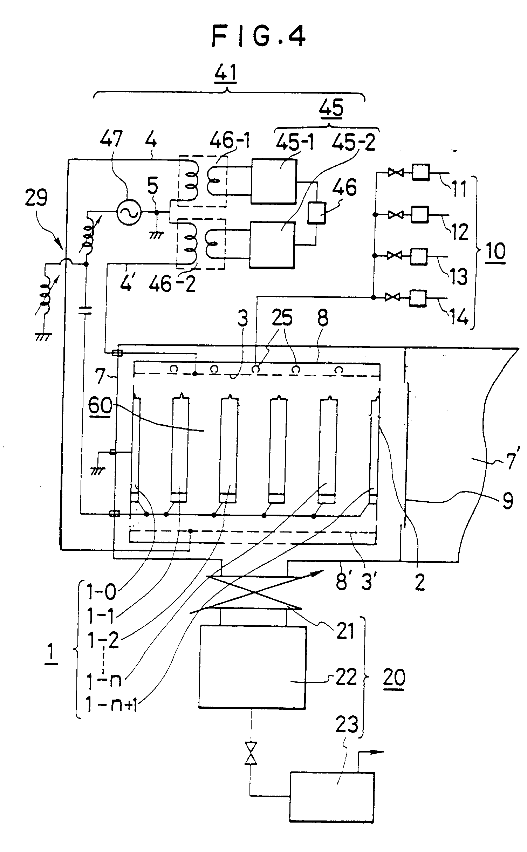

Referring now to Fig. 4, another embodiment of the invention will now be described. Similar elements to those described with reference to Fig. 1 are given the same reference numerals in Fig. 4 and no redundant explanation for such elements will be given.

The power source 41 is a particular feature of the Fig. 4 embodiment. The source 41 comprises a pair of high frequency sources 45-1 and 45-2 which are coupled by a phase shifter 46. The phase difference between the outputs of the sources 45-1 and 45-2 is controlled by means of the phase shifter 46. The outputs of the sources 45-1 and 45-2 are coupled to a pair of matching transformers 46-1 and 46-2 which, in turn, are coupled in series with each other at respective terminals of their secondary coils, the other terminals of the secondary coils of the transformers 46-1 and 46-2 being connected to the pair of mesh electrodes 3, 3' in the same manner as in the first embodiment. An AC power source 47 and a bias arrangement 29 are connected between the pair of mesh electrodes 3 and 3' in the same manner as in the first embodiment.

The relative phases of the electric voltages applied to the electrodes 3 and 3' are controlled by means of the phase shifter 46 in order to ensure a uniform distribution of plasma throughout the reaction space. The potentials at the pair of electrodes 3 and 3' are basically maintained in phase or in phase opposition, but phase difference may be adjusted to any other suitable angle to adapt to the arrangement of the electrodes within the enclosure 2.

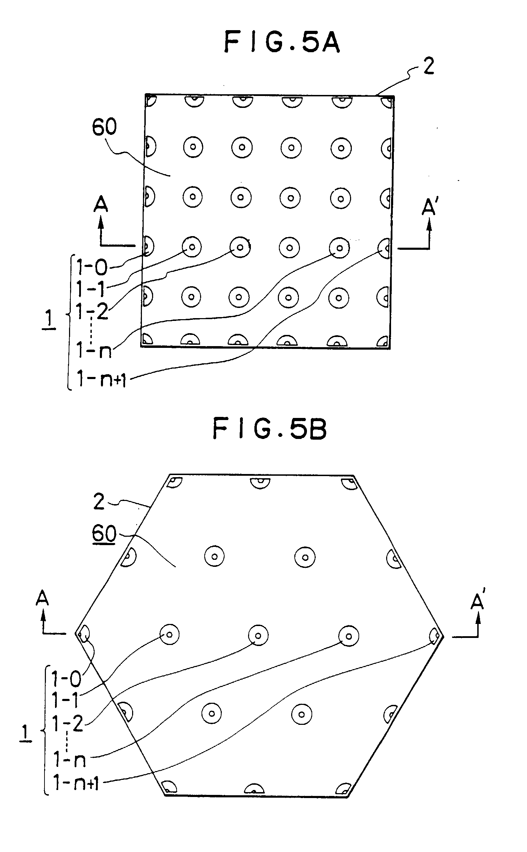

Next, an exemplary deposition method by use of the apparatus of Fig. 4 will be explained. A number of printing drums 1 for electrostatic copying machines are mounted on substrate holders which are integrally formed as parts of the enclosure 2. The surfaces of the printing drums have previously been coated with an organic photoconductive film. An exemplary mounting arrangement of the drums in a 50 cm high square enclosure of 75 cm side wall is illustrated in Fig. 5(A) which shows 16 drums to be coated mounted spaced apart from the walls of the enclosure while dummy drums 1-0 are provided along the inner surface of the enclosure in order to make the electric field induced in the plasma generating space 60 more uniform. Fig. 5(B) shows an alternative arrangement of drums mounted in a hexagonal enclosure.

NF₃ and C₂H₂ for example are introduced into the reaction chamber as a reactive gas. The ratio of NF₃/C₂H₂ may be from 1/4 to 4/1, e.g. 1/1. By virtue of the high frequency energy input from the power source 45, a plasma is generated and a carbon film is deposited on the drums. The carbon film is formed while being subjected to a sputtering action which is mainly induced by the power source 47. As a result, the carbon film becomes a diamond like carbon film containing nitrogen at 0.3 to 10 atom% and fluorine at 0.3 to 3 atom%. The transparency and the resistivity of the diamond like carbon can be controlled by varying the proportions of nitrogen and fluorine. From the viewpoint of the application to printing drums, a suitable resistivity may be found in the range of 1 x 10⁷ to 1 x 10¹⁴ ohm cm, preferably 1 x 10⁹ to 1 x 10¹¹ ohm cm.

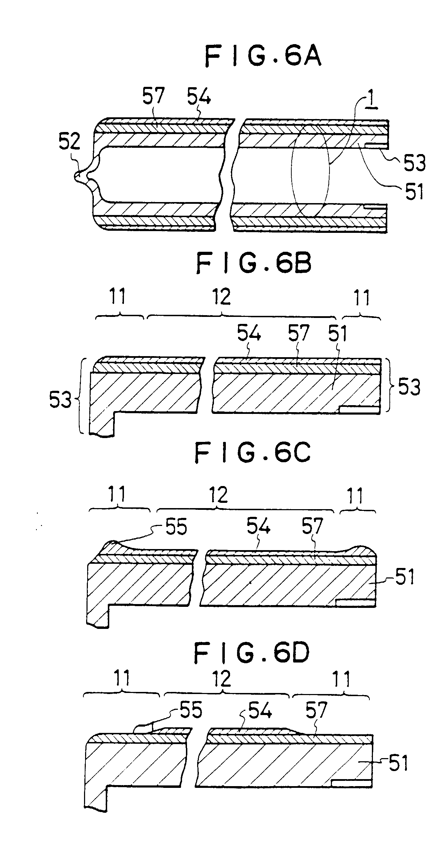

Fig. 6(A) is a cross sectional view showing the form of a printing drum. The drum comprises an aluminium cylinder 51 having one end closed and provided with a projection 52 for enabling the drums to be rotatably supported in a copying machine. The inner surface of the other end of the drum is screw-threaded at 53. A photosensitive dual film 57 consisting of an organic photoconductor film and a carrier transmission film is coated on the aluminium cylinder 51. The carbon film 54 is formed so as to cover the dual film 57. The thickness of the carbon film may be from 0.1 to 3.0 µm (0.1 to 3.0 microns). Fig. 6(B) is an enlarged view of part of Fig. 6(A). Since the drum is repeatedly subjected to a rubbing action in use, it may happen that the end portions 11 of the carbon film get rubbed away. In order to strengthen the end portions, it may be desirable to thicken them as illustrated in Fig. 6(C). The thickened portion 55 can be formed by locating the end portions near to the mesh electrodes 3 and 3' and adjusting the plasma pressure to be in a range of from 10.66 to 13.33 Pa (0.08 to 0.1 Torr) . The configuration shown in Fig. 6(B) is realised when the plasma pressure is 6.67 Pa (0.05 Torr). Otherwise, the end portions of the carbon film may be dispensed with as shown in Fig. 6(D). This can be realised by adjusting the plasma pressure to be in a range of from 1.33 to 5.33 Pa (0.01 to 0.04 Torr) or by masking the end portions with suitable covers.

After completion of the deposition, the drums are removed from the chamber, and the inside of the chamber, which may have undesired carbon deposits may be cleaned by introducing an etchant comprising oxygen and effecting plasma etching. Subsequently, H₂ plasma etching may be effected to eliminate oxide contaminants attached to the inside of the reaction chamber. Otherwise, the deposition and etching conditions are the same as for the plasma process of the first embodiment.

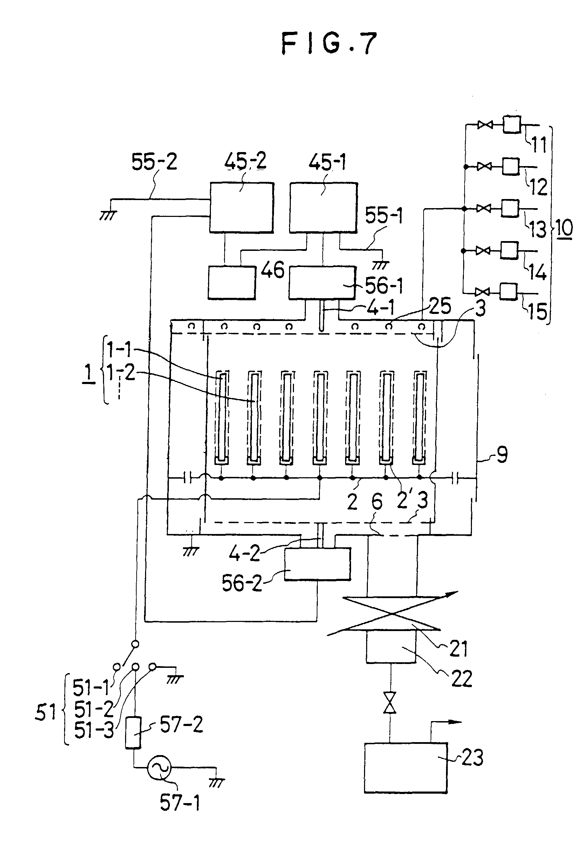

A modification of the apparatus shown in Fig. 4 is illustrated in Fig. 7. The same reference numerals are given to the same or similar elements in Fig. 7 as in Fig. 4. 56-1 and 56-2 are matching boxes of LCR by means of which impedance matching between the electrodes 3 and 3' and the high frequency electric power sources 45-1 and 45-2 is established. The electric power sources are provided with earth lines 55-1 and 55-2. The frequency of one of the electric power sources is equal to or a multiple of that of the other. An intermediate voltage supply is connected to the substrate holder 2' and comprises an AC voltage source 57-1, a DC voltage source 57-2, and a three-way switch 51. The DC voltage source 57-2 functions to superimpose a DC bias voltage on the AC voltage from the AC voltage source 57-1. The frequency of the AC voltage source is from 10Hz to 100KHz. By means of the switch 51, three states of bias application can be selected. The substrates 1 are rendered electrically floating with the switch at 51-1, are subjected to the AC voltage from the AC source 57-1 biassed by the DC voltage of the source 57-2 with the switch at 51-2, and are earthed with the switch at 51-3. In the case of this embodiment, the input energy is 0.5 to 50 KW (0.005 to 5 W/cm²), for example 1 KW (0.1 W/cm²).

The phase difference between the voltages at the electrodes 3 and 3' is adjusted by means of phase shifter 46 in order to spread plasma gas over the whole of the deposition space. If the deposition system is exactly symmetrical with respect to the electrodes 3 and 3', the phase difference will be set to 0 to Π rad (0° or 180°). However, depending on any assymetry that might exist, the optimum value may be displaced from 0 to Π rad (0° or 180°). In accordance with experimental results, the optimum phase difference values were found to be in a range of ±Π/6 rad or Π rad ±Π/6 rad (±30° or 180° ±30°). Plasma gas tended to collect mainly near one of the electrodes 3, 3' when the phase difference was around Π/2 rad to 3Π/4 rad (±Π/6 rad) (90° or 270° (±30°)).

Carbon films were deposited on printing drums 1 coated with organic photoconductive films by means of the apparatus of Fig. 7. The reactive gas, consisting of C₂F₆/C₂H₄ (=1/4 to 4/1), was introduced to the chamber downwardly from nozzles 25. The drums were not specially heated and were maintained within a temperature range of room temperature to 150°C. A negative bias voltage of -50 to -600 V was established by applying an AC bias voltage from the intermediate voltage supply 57-1. Other deposition conditions were the same as for the first embodiment described hereinbefore. Then, diamond like carbon films containing fluorine and of 0.1 to 8 µm (0.1 to 8 microns) thickness were formed on the drums at a deposition speed of 100 nm/min (1000Å/min).

The formation was carried out in two steps. First, ethylene and hydrogen were used in order to deposit carbon thin films of 0.01 to 0.1 µm (0.01 to 0.1 micron) thickness which has a high adhesitivity to the organic surface of the drums. The resistivity of the films was 1 x 10⁶ to 5 x 10¹³ ohm cm. Next, 0.2 to 2 µm (0.2 to 2 microns) thick carbon films were deposited on the underlying thin carbon films by use of a reactive gas consisting of C₂F₆ and NH₃. The resistivity of the films was 1 x 10⁷ to 5 x 10¹² ohm cm.

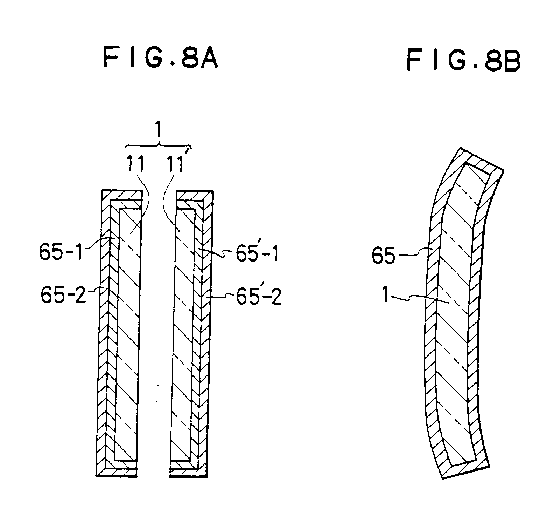

Referring to Fig. 8(A), the deposition of silicon nitride films and fluorine containing carbon films will now be explained. Glass substrates 11 and 11' are supported on the substrate holder. The substrates are, for example, front, side and rear window panes and side mirrors of motor-cars, and similar parts for motorcycles, other road or rail vehicles or airplanes, or windows for buildings. In this embodiment, a silicon nitride film 65-1 is formed on the substrate in advance of the carbon coating 65-2 because glass tends to react with fluoride. The resistivity of the carbon films was adjusted to be 1 x 10⁶ to 5 x 10¹³ ohm cm by controlling the introduction of fluorine in order to prevent the finished product from gathering dust due to electrostatic effects. Fig. 8(B) shows the deposition on a curved surface.

While several embodiments of the invention have been specifically described, it is to be appreciated that the present invention is not limited to the particular examples described and that modifications and variations can be made without departure from the scope of the invention as defined by the appended claims. Some examples of such modifications are as follows.

Since the thermal conductivity coefficient of carbon films formed in accordance with an embodiment of the present invention is very high, thermal diffusion of IC chips may be expedited by coating their rear surfaces with the carbon film in advance.

The substrate to be coated in accordance with an embodiment of the present invention may be made of any material, such as plastics, e.g. PET (polyethyleneterephthalate), PES, PMMA, tefon, epoxy, polyimide or other organic resin. The substrate can take substantially any shape and can have irregular surfaces.

The materials that can be deposited on a substrate in accordance with the teachings of the present invention are not limited to carbon, and can include silicon oxide, silicon nitride, and other materials.

An excellent loudspeaker can be realised by utilising a vibration cone whose inside and outside surfaces have been coated with a very hard carbon film in accordance with an embodiment of the present invention.

Both side surfaces can be coated at once in a reaction chamber according to an embodiment of the present invention.

## Claims

1. A plasma chemical vapour deposition method in which a plasma is generated for deposition throughout a plasma generating space provided between a pair of electrodes (3,3') in a reaction chamber (7), said method comprising:
disposing in the plasma generating space at least one substrate (1) on a substrate holder (1',2',2") spaced apart from said pair of electrodes (3,3');
supplying a reactive gas to said plasma generating space;
inducing the plasma throughout said plasma generating space by applying high-frequency electrical energy to said reactive gas;
depositing a material on the surface of said substrate (1) from said reactive gas through a chemical vapour deposition; and
applying a bias voltage to said substrate (1) during said deposition;
characterised in that
said bias voltage comprises alternating current electrical energy and is applied in order to expedite sputtering action at said surface.

2. The method of claim 1 wherein said alternating current bias voltage has a frequency lower than the frequency of said high frequency electrical energy.

3. A plasma processing method in which a plasma is generated throughout a plasma generating space provided between a pair of electrodes (3,3') in a reaction chamber (7), said method comprising:
placing in said plasma generating space at least one substrate (1) on a substrate holder (1',2',2") spaced apart from said pair of electrodes (3,3');
introducing a reactive gas into said reaction chamber (7);
supplying an AC voltage between said pair of electrodes (3,3') in order to convert said reactive gas to a plasma;
treating a surface of said substrate (1) with said plasma; and
applying a bias voltage to said substrate (1);
characterised in that
said bias voltage comprises alternating current electrical energy and is applied in order to expedite sputtering action at said surface.

4. The method of claims 3 wherein said AC voltage is supplied from a secondary coil of a transformer 16.

5. The method of claim 4, wherein said bias voltage is provided by an AC voltage source (17) and one end thereof is connected to a midpoint (5) of said secondary coil.

6. The method of claim 3 wherein said supplying an AC voltage between a pair of electrodes (3,3') comprises:
applying a first AC voltage to one of said pair of electrodes (3,3'); and
applying a second AC voltage to the other one of said pair of electrodes (3,3'), said second AC voltage being phase-shifted from said first AC voltage.

7. The method of any of claims 3 to 6, wherein the bias voltage has frequency lower than that of said AC voltage or said first and second AC voltages.

8. The method of any of claims 3 to 7 wherein said AC voltage or each of said first and second AC voltages applied to said pair of electrodes (3,3') has a frequency in the range of 1-50 MHz.

9. The method of any of claims 3 to 8 wherein said bias voltage has a frequency in the range of 1-500 kHz.

10. The method of any of claims 3 to 9, wherein said bias voltage is applied with a negative DC bias at the substrate (1).

11. The method of any of claims 3 to 10 wherein the distribution of plasma throughout the plasma generating space is controlled by adjusting the relative phases of the electrical inputs thereto.

12. The method of any preceding claim wherein the plasma is formed so as to effect the deposition of carbon, or silicon oxide or silicon nitride.

13. The method of any preceding claim further comprising introducing microwave energy into said reaction chamber (7).

14. A plasma processing apparatus comprising:
a reaction chamber (7);
a gas supply system (10) associated with said chamber for supplying process gases thereto;
a vacuum pump (22,23) for evacuating said reaction chamber and maintaining a suitable gas pressure in said reaction chamber;
first and second parallel electrodes (3,3') spaced apart from each other in said reaction chamber (7); a plasma generating space provided between said first and second electrodes;
a substrate holder (2) provided in said plasma generating space and spaced apart from each of said first and second electrodes;
a high-frequency power source (15) for applying high-frequency electrical energy between said first and second electrodes at a frequency for effecting the generation of a plasma throughout said plasma generating space when process gases are introduced into the reaction chamber; and
a biassing power source (17) for applying a bias voltage to said substrate holder (1',2',2");
characterised in that
said biassing power source (17) comprises an alternating current power source such that a substrate supported by said substrate holder will be substantially subjected to sputtering action of the plasma generated throughout the plasma generating space.

15. The apparatus of claim 14, wherein the apparatus is adapted for the deposition of thin films onto a substrate, said gas supply system (10) is adapted for supplying reaction gases to said reaction chamber (7), and said bias voltage is selected for depositing products of the plasma reaction onto a substrate held by the substrate holder.

16. The apparatus of claim 14 or 15, wherein said high-frequency power source (15) includes a transformer (16), one terminal (4) of the secondary coil of the transformer being connected to one of said first and second electrodes (3) and the other terminal (4') being connected to the other of said first and second electrodes (3').

17. The apparatus of claim 16 wherein one output terminal (5) of said biassing power source (17) is connected to a mid point of the secondary coil of said transformer (16) and the other output terminal of said biassing power source (17) is connected in use of the apparatus to said substrate holder.

18. The apparatus of any of claims 14 to 17, wherein the frequency of the electrical energy furnished by the high-frequency power source (15) is in the range of 1 MHz to 50 MHz and the frequency of the bias voltage furnished by the biassing power source (17) is in the range 1 KHz to 500 KHz.

19. The apparatus of any of claims 14 to 18 wherein at least one of said first and second electrodes (3,3') is a conductive mesh.

20. The apparatus of any of claims 14 to 19 wherein said plasma generating space is confined by an enclosure with which said substrate holder is integrally formed.

21. The apparatus of any of claims 14 to 20 wherein said high frequency power supply is provided with a phase shifter by means of which the phase difference between the inputs to said electrodes can be adjusted.

22. The apparatus of any of claims 14 to 21 wherein said substrate holder is provided with an electrically conductive surface adapted to make electrical contact with a substrate supported by said holder.

## Patentansprüche

1. Verfahren zur chemischen Plasma-Gasphasenabscheidung, wobei zur Abscheidung ein Plasma über einen ganzen Plasmaerzeugungsraum erzeugt wird, mit folgenden Schritten:
Anordnen mindestens eines Substrats (1) in dem Plasmaerzeugungsraum,
Liefern eines reaktiven Gases an den Plasmaerzeugungsraum,
Erzeugen des Plasmas über den gesamten Plasmaerzeugungsraum durch Anlegen von elektrischer Hochfrequenzenergie an das reaktive Gas,
Abscheiden eines Materials auf der Oberfläche des Substrats (1) aus dem reaktiven Gas durch chemische Gasphasenabscheidung, und
Anlegen einer Vorspannung an das Substrat (1) während der Abscheidung,
dadurch **gekennzeichnet**, daß
die Vorspannung eine elektrische Wechselstromenergie aufweist und zur Beschleunigung eines Sputtervorgangs an der genannten Oberfläche angelegt wird.

2. Verfahren nach Anspruch 1, wobei die Wechselstrom-Vorspannung eine niedrigere Frequenz als die genannte elektrische Hochfrequenzenergie aufweist.

3. Verfahren zur Herstellung eines Plasmas, wobei ein Plasma über einen gesamten Plasmaerzeugungsraum erzeugt wird, mit folgenden Schritten:
Vorsehen eines Elektrodenpaars (3, 3') in einer Reaktionskammer (7),
Anordnen mindestens eines Substrats (1) in dem Plasmaerzeugungsraum zwischen den Elektroden (3, 3') des Paars und mit Abstand zu diesen,
Einleiten eines reaktiven Gases in die Reaktionskammer (7),
Anlegen einer Wechselspannung an das Elektrodenpaar (3, 3'), um das reaktive Gas in ein Plasma zu verwandeln,
Behandeln einer Oberfläche des Substrats (1) mit dem Plasma, und
Anlegen einer Vorspannung an das Substrat (1),
dadurch gekennzeichnet, daß
die Vorspannung eine elektrische Wechselstromenergie beinhaltet und angelegt wird, um einen Sputtervorgang an der genannten Oberfläche zu beschleunigen.

4. Verfahren nach Anspruch 3, wobei die Wechselspannung von einer Sekundärspule eines Transformators (16) geliefert wird.

5. Verfahren nach Anspruch 4, wobei die Vorspannung von einer Wechselspannungsquelle (17) geliefert wird, deren eines Ende mit einem Mittelabgriff (5) der Sekundärspule verbunden ist.

6. Verfahren nach Anspruch 3, wobei das Anlagen einer Wechselspannung an die Elektroden (3, 3') des Paars folgende Schritte beinhaltet:
Anlegen einer ersten Wechselspannung an eine der Elektroden des Paars (3, 3'), und
Anlegen einer zweiten Wechselspannung an die andere Elektrode des Paars (3, 3'), wobei die zweite Wechselspannung bezüglich der ersten Wechselspannung phasenverschoben ist.

7. Verfahren nach einem der Ansprüche 3 bis 6, wobei die Vorspannung eine niedrigere Frequenz als die Wechselspannung oder die erste und die zweite Wechselspannung aufweist.

8. Verfahren nach einem der Ansprüche 3 bis 7, wobei die Wechselspannung oder die erste und die zweite Wechselspannung, die an das Elektrodenpaar (3, 3') angelegt werden, eine Frequenz im Bereich von 1 bis 50 MHz aufweisen.

9. Verfahren nach einem der Ansprüche 3 bis 8, wobei die Vorspannung eine Frequenz im Bereich von 1 bis 500 kHz aufweist.

10. Verfahren nach einem der Ansprüche 3 bis 9, wobei die Vorspannung mit einer negativen Gleich-Vorspannung am Substrat (1) angelegt wird.

11. Verfahren nach einem der Ansprüche 3 bis 10, wobei die Verteilung des Plasmas über den Plasmaerzeugungsraum durch Einstellen der relativen Phasen seiner elektrischen Eingangsgrößen gesteuert wird.

12. Verfahren nach einem der vorhergehenden Ansprüche, wobei das Plasma so gebildet wird, daß es die Abscheidung von Kohlenstoff, Siliziumoxid oder Siliziumnitrid bewirkt.

13. Verfahren nach einem der vorhergehenden Ansprüche mit einem Schritt zur Einleitung von Mikrowellenenergie in die Reaktionskammer (7).

14. Plasmaerzeugende Vorrichtung, aufweisend:
eine Reaktionskammer (7),
ein Gaszuführsystem (10), das der Kammer zugeordnet ist, um ihr Prozeßgase zuzuführen,
eine Vakuumpumpe (22, 23), um die Reaktionskammer zu evakuieren und einen geeigneten Gasdruck in ihr aufrecht zu erhalten,
eine erste und eine zweite parallele Elektrode (3, 3'), die mit Abstand zueinander in der Reaktionskammer (7) angeordnet sind und zwischen denen mit Abstand zu ihnen ein Plasmaerzeugungsraum vorgesehen ist,
einen Substrathalter (2), der in dem Plasmaerzeugungsraum mit Abstand zu der ersten und der zweiten Elektrode vorgesehen ist,
eine Hochfrequenzquelle (15) zum Anlegen einer elektrischen Hochfrequenzenergie an die erste und die zweite Elektrode bei einer Frequenz, die die Plasmaerzeugung über den gesamten Plasmaerzeugungsraum bewirkt, wenn Prozeßgase in die Reaktionskammer eingeleitet werden, und
eine Vorspannungsquelle (17), um eine Vorspannung an den Substrathalter (2) anzulegen,
dadurch gekennzeichnet, daß
die Vorspannungsquelle (17) eine Wechselstromquelle aufweist, so daß ein von dem Substrathalter getragenes Substrat im wesentlichen einem Sputtervorgang des über den Plasmaerzeugungsraum erzeugten Plasmas unterworfen wird.

15. Vorrichtung nach Anspruch 14, die zur Abscheidung dünner Filme auf einem Substrat eingerichtet ist, wobei das Gaszuführsystem (10) zur Zufuhr von Reaktionsgasen an die Reaktionskammer (7) eingerichtet ist und die Vorspannung zum Abscheiden von Produkten der Plasmareaktion auf einem vom Substrathalter gehaltenen Substrat ausgewählt ist.

16. Vorrichtung nach Anspruch 14 oder 15, wobei die Hochfrequenzquelle (15) einen Transformator (16) beinhaltet, wobei ein Anschluß (4) der Sekundärspule des Transformators mit einer der genannten beiden Elektroden (3) und der andere Anschluß (4') mit der anderen der genannten beiden Elektroden (3') verbunden ist.

17. Vorrichtung nach Anspruch 16, wobei ein Ausgangsanschluß (5') der Vorspannungsquelle (17) mit einem Mittelabgriff der Sekundärspule des Transformators (16) und der andere Ausgangsanschluß (5) der Vorspannungsquelle (17) im Gebrauch der Vorrichtung mit dem Substrathalter (2) verbunden ist.

18. Vorrichtung nach einem der Ansprüche 14 bis 17, wobei die Frequenz der von der Hochfrequenzquelle (15) gelieferten elektrischen Energie im Bereich von 1 MHz bis 50 MHz und die Frequenz der von der Vorspannungsquelle (17) gelieferten Vorspannung im Bereich von 1 KHz bis 500 KHz liegt.

19. Vorrichtung nach einem der Ansprüche 14 bis 18, wobei die erste und/oder die zweite Elektrode (3, 3') ein leitfähiges Gitter darstellt.

20. Vorrichtung nach einem der Ansprüche 14 bis 19, wobei der Plasmaerzeugungsraum von einer Hülle umschlossen ist, mit der der Substrathalter einstückig geformt ist.

21. Vorrichtung nach einem der Ansprüche 14 bis 20, wobei die Hochfrequenzquelle mit einem Phasenschieber versehen ist, mittels dem die Phasendifferenz zwischen Eingangsgrößen der Elektroden eingestellt werden kann.

22. Vorrichtung nach einem der Ansprüche 14 bis 21, wobei der Substrathalter mit einer elektrisch leitfähigen Fläche versehen ist, die einen elektrischen Kontakt zu einem von dem Halter getragenen Substrat herstellen kann.

## Revendications

1. Procédé de dépôt chimique en phase vapeur sous plasma, dans lequel un plasma est généré en vue d'un dépôt dans l'ensemble d'un espace générateur de plasma, ledit procédé comprenant les opérations consistant à :
- disposer au moins un substrat (1) dans l'espace générateur de plasma ;
- fournir un gaz réactif audit espace générateur de plasma ;
- induire le plasma dans l'ensemble dudit espace générateur de plasma par application d'une énergie électrique haute fréquence audit gaz réactif ;
- déposer une matière sur la surface dudit substrat (1) à partir dudit gaz réactif grâce à une dépôt chimique en phase vapeur ; et
- appliquer une tension de polarisation audit substrat (1) pendant ledit dépôt ;
caractérisé en ce que ladite tension de polarisation comprend une énergie électrique de courant alternatif et est appliquée afin d'accélérer l'action de pulvérisation cathodique au niveau de ladite surface.

2. Procédé selon la revendication 1, dans lequel ladite tension de polarisation de courant alternatif a une fréquence inférieure à la fréquence de ladite énergie électrique haute fréquence.

3. Procédé de traitement sous plasma, dans lequel un plasma est généré dans l'ensemble d'un espace générateur de plasma, ledit procédé comprenant les opérations consistant à :
- disposer deux électrodes (3, 3') dans une chambre de réaction (7) ;
- placer au moins un substrat (1) dans l'espace générateur de plasma prévu entre les deux électrodes (3, 3') et espacé de celles-ci ;
- introduire un gaz réactif dans ladite chambre de réaction (7) ;
- fournir une tension alternative entre les deux électrodes (3, 3') afin de convertir ledit gaz réactif en un plasma ;
- traiter une surface dudit substrat (1) par ledit plasma ; et
- appliquer une tension de polarisation audit substrat (1) ;
caractérisé en ce que ladite tension de polarisation comprend l'énergie électrique de courant alternatif et est appliquée afin d'accélérer l'action de pulvérisation cathodique au niveau de ladite surface.

4. Procédé selon la revendication 3, dans lequel ladite tension alternative est fournie à partir d'un enroulement secondaire d'un transformateur (16).

5. Procédé selon le revendication 4, dans lequel ladite tension de polarisation est fournie par une source de tension alternative (17) et l'une des bornes de celle-ci est connectée à un point central (5) dudit enroulement secondaire.

6. Procédé selon la revendication 3, dans lequel ladite fourniture d'une tension alternative entre deux électrodes (3, 3') comprend les opérations consistant à:
- appliquer une première tension alternative à l'une des deux électrodes (3, 3'); et
- appliquer une seconde tension alternative à l'autre des deux électrodes (3, 3'), ladite seconde tension alternative étant décalée en phase par rapport à ladite première tension alternative.

7. Procédé selon l'une quelconque des revendications 3 à 6, dans lequel la tension de polarisation a une fréquence inférieure à celle de ladite tension alternative ou desdites première et seconde tensions alternatives.

8. Procédé selon l'une quelconque des revendications 3 à 7, dans lequel ladite tension alternative ou chacune desdites première et seconde tensions alternatives appliquées aux deux électrodes (3, 3') a une fréquence se situant dans la plage de 1-50 MHz.

9. Procédé selon l'une quelconque des revendications 3 à 8, dans lequel ladite tension de polarisation a une fréquence se situant dans la plage de 1-500 kHz.

10. Procédé selon l'une quelconque des revendications 3 à 9, dans lequel ladite tension de polarisation est appliquée avec une polarisation continue négative au niveau du substrat (1).

11. Procédé selon l'une quelconque des revendications 3 à 10, dans lequel la répartition du plasma dans l'ensemble de l'espace générateur de plasma est contrôlée par l'ajustement des phases relatives des entrées électriques dans celui-ci.

12. Procédé selon l'une quelconqiedes revendications précédentes, dans lequel le plasma est formé de façon à effectuer le dépôt de carbone, ou d'oxyde de silicium ou de nitrure de silicium.

13. Procédé selon l'une quelconque des revendications précédentes, comprenant en outre l'introduction d'énergie hyperfréquence dans ladite chambre de réaction (7).

14. Appareil de traitement sous plasma comprenant :
- une chambre de réaction (7) ;
- un système de fourniture de gaz (10), associé à ladite chambre pour fournir des gaz de traitement à celle-ci;
- une pompe à vide (22, 23) pour réaliser un vide dans ladite chambre de réaction et maintenir une pression de gaz appropriée dans ladite chambre de réaction ;
- des première et seconde électrodes parallèles (3, 3') espacées l'une de l'autre dans ladite chambre de réaction (7) ; un espace générateur de plasma prévu entre lesdites première et seconde électrodes et espacé de celles-ci ;
- un support de substrat (2) prévu dans ledit espace générateur de plasma et espacé de chacune desdites première et seconde électrodes ;
- une source de courant haute fréquence (15) pour appliquer une énergie électrique haute fréquence entre lesdites première et seconde électrodes à une fréquence appropriée pour effectuer la génération d'un plasma dans l'ensemble dudit espace générateur de plasma lorsque des gaz de traitement sont introduits dans la chambre de réaction ; et
- une source de courant de polarisation (17) pour appliquer une tension de polarisation audit support de substrat (2) ;
caractérisé en ce que ladite source de courant de polarisation (17) comprend une source de courant alternatif afin qu'un substrat supporté par ledit support de substrat soit sensiblement soumis à une action de pulvérisation cathodique du plasma généré dans l'ensemble de l'espace générateur de plasma.

15. Appareil selon la revendication 14, dans lequel l'appareil est adapté pour le dépôt de films minces sur un substrat, ledit système de fourniture de gaz (10) est adapté pour fournir des gaz de réaction à ladite chambre de réaction (7), et ladite tension de polarisation est choisie pour déposer des produits de la réaction du plasma sur un substrat maintenu par le support de substrat.

16. Appareil selon la revendication 14 ou 15, dans lequel ladite source de courant haute fréquence (15) comprend un transformateur (16), l'une des bornes (4) de l'enroulement secondaire du transformateur étant connectée à l'une desdites première et seconde électrodes (3) et l'autre borne (4') étant connectée à l'autre desdites première et seconde électrodes (3').

17. Appareil selon la revendication 16, dans lequel l'une des bornes de sortie (5') de ladite source de courant de polarisation (17) est connectée à un point central de l'enroulement secondaire dudit transformateur (16), et l'autre borne de sortie (5) de ladite source de courant de polarisation (17) est connectée, lors de l'utilisation de l'appareil, audit support de substrat (2).

18. Appareil selon l'une quelconque des revendications 14 à 17, dans lequel la fréquence de l'énergie électrique fournie par la source de courant haute fréquence (15) se situe dans la plage de 1 MHz à 50 MHz et la fréquence de la tension de polarisation fournie par la source de courant de polarisation (17) se situe dans la plage de 1 kHz à 500 kHz.

19. Appareil selon l'une quelconque des revendications 14 à 18, dans lequel au moins l'une desdites première et seconde électrodes (3, 3') est une grille à mailles conductrice.

20. Appareil selon l'une quelconque des revendications 14 à 19, dans lequel ledit espace générateur de plasma est enfermé par une enceinte avec laquelle ledit support de substrat est formé d'un seul tenant.

21. Appareil selon l'une quelconque des revendications 14 à 20, dans lequel ladite alimentation en courant haute fréquence est dotée d'un déphaseur au moyen duquel la différence de phase entre les entrées sur lesdites électrodes peut être ajustée.

22. Appareil selon l'une quelconque des revendications 14 à 21, dans lequel ledit support de substrat est doté d'une surface conductrice de l'électricité, adaptée pour faire contact électrique avec un substrat supporté par ledit support.
